(19) Europäisches Patentamt
European Patent Office
Office européen des brevets

(11) Veröffentlichungsnummer : **0 367 131 B1**

(12) # EUROPÄISCHE PATENTSCHRIFT

(45) Veröffentlichungstag der Patentschrift :
**22.02.95 Patentblatt 95/08**

(51) Int. Cl.$^6$ : **G03F 7/004**

(21) Anmeldenummer : **89119965.5**

(22) Anmeldetag : **27.10.89**

(54) **Strahlungsempfindliches Gemisch.**

(30) Priorität : **04.11.88 DE 3837438**

(43) Veröffentlichungstag der Anmeldung :
**09.05.90 Patentblatt 90/19**

(45) Bekanntmachung des Hinweises auf die Patenterteilung :
**22.02.95 Patentblatt 95/08**

(84) Benannte Vertragsstaaten :
**BE DE FR GB IT NL**

(56) Entgegenhaltungen :
**EP-A- 0 029 901**

(56) Entgegenhaltungen :
**JOURNAL OF IMAGING TECHNOLOGY, vol. 11, no. 4, August 1985, SPRINGFIELD US, Seiten 146-157; PAPPAS S.P.: "PHOTOGENERATION OF ACID: PART 6* -A REVIEW OF BASIC PRINCIPLES FOR RESIST IMAGING APPLICATIONS"**

(73) Patentinhaber : **BASF Aktiengesellschaft
Carl-Bosch-Strasse 38
D-67063 Ludwigshafen (DE)**

(72) Erfinder : **Nguyen-Kim, Son, Dr.
Zedernweg 9
D-6944 Hemsbach (DE)**
Erfinder : **Hoffmann, Gerhard, Dr.
Pappelstrasse 22
D-6701 Otterstadt (DE)**
Erfinder : **Schwalm, Reinhold, Dr.
Am Huettenwingert 53
D-6706 Wachenheim (DE)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 367 131 B1

Jouve, 18, rue Saint-Denis, 75001 PARIS

## Beschreibung

Die Erfindung betrifft positiv arbeitende strahlungsempfindliche Gemische, die ein in Wasser unlösliches, in wäßrig-alkalischen Lösungen lösliches Bindemittel, eine unter Einwirkung von Strahlung eine Säure bildende Verbindung und eine organische Verbindung, die durch säurekatalytische Einwirkung verseift und decarboxyliert wird, wodurch die Alkalilöslichkeit des Gemisches erhöht wird, enthalten. Diese Gemische sind sensitiv gegenüber UV-, Elektronen- und Röntgenstrahlen und eignen sich besonders als Resistmaterial.

Positiv arbeitende strahlungsempfindliche Gemische sind bekannt und besonders positiv arbeitende Resistmaterialien, die o-Chinondiazide in wäßrig-alkalisch löslichen Bindemitteln, z.B. Novolaken oder Poly(p-vinylphenol)en, enthalten, werden kommerziell eingesetzt. Die Empfindlichkeit dieser Systeme gegenüber Strahlung, insbesondere kurzwelliger Strahlung, ist jedoch teilweise unbefriedigend.

Empfindlichkeitserhöhungen in strahlungsempfindlichen Systemen, die in der Primärfotoreaktion eine Spezies erzeugen, die dann unabhängig von der Strahlung eine katalytische Sekundärreaktion auslösen, sind beschrieben. So sind in der US-A 3,915,706 beispielsweise Photoinitiatoren beschrieben, die eine starke Säure erzeugen, die dann in einer Sekundärreaktion säurelabile Gruppen, wie Polyaldehydgruppierungen spalten.

Weiterhin sind strahlungsempfindliche Gemische auf Basis von säurespaltbaren Verbindungen bekannt, die als Bindemittel ein wäßrig-alkalisch lösliches Polymer sowie eine Verbindung die photochemisch eine starke Säure bildet und eine weitere Verbindung mit durch Säure spaltbaren Bindungen, die durch die Einwirkung der Säure ihre Löslichkeit in einem alkalischen Entwickler erhöhen, enthalten (vgl. DE-A 3 406 927). Als photochemisch eine starke Säure bildende Verbindungen werden Diazonium-, Phosphonium-, Sulfonium- und Iodonium-, sowie Halogenverbindungen genannt. Die Verwendung dieser Oniumsalze als photochemische Säurespender in Resistmaterialien ist z.B. auch aus US-A 4,491,628 bekannt. Einen Überblick über die Anwendung von Oniumsalzen in Resistmaterialien gibt Crivello in Org. Coatings and Appl. Polym. Sci., 48, p. 65-69 (1985).

Strahlungsempfindliche Gemische von Polymeren mit säurelabilen Seitengruppen und photochemischen Säurespendern sind z.B. aus US-A 4,491,628 und FR-A 2,570,844 bekannt. Diese polymeren Bindemittel sind jedoch hydrophob und werden erst nach der Belichtung alkalilöslich.

Copolymere mit phenolischen und säurelabilen Gruppen, wie beispielsweise Poly-(p-hydroxistyrol-co-t-butoxicarbonyloxistyrol), sind aus J. Polym. Sci., Part A, Polym. Chem. Ed., Vol. 24, 2971-2980 (1986) bekannt. Verwendet man jedoch diejenigen Copolymeren dieser Gruppe, die noch alkalilöslich sind, in Verbindung mit den kommerziellen Sulfoniumsalzen, wie Triphenylphosphoniumhexafluoroarsenat, wie auch in US-A 4,491,628 beschrieben, so haben diese Gemische den Nachteil, daß ein sehr hoher Abtrag der unbelichteten Bereiche stattfindet, da die genannten Sulfoniumsalze nicht genügend zur Löslichkeitsinhibierung beitragen.

In der EP 0 029 901-A1 wird eine lithographische Resistzusammensetzung beschrieben, die aus Phenol/Aldehyd-Harz, Diazonaphthochinon und einem Meldrum's Säure(-derivat) als profile modifying agent besteht.

In Journal of Imaging Technology, 11 (1985) Aug., No. 4, 146-157 werden Aryldiazonium-, Diaryljodonium- und Triarylsulfoniumsalze als bei Bestrahlung eine starke Säure bildende Verbindungen aufgeführt.

In der DE-A 37 21 741 werden strahlungsempfindliche Gemische beschrieben, die ein in wäßrig-alkalischen Lösungen lösliches polymeres Bindemittel enthalten sowie eine organische Verbindung, deren Löslichkeit in einem wäßrig-alkalischen Entwickler durch Einwirkung von Säure erhöht wird und die mindestens eine durch Säure spaltbare Gruppierung enthält, wobei diese organische Verbindung unter Einwirkung von Strahlung eine starke Säure erzeugt.

Aufgabe der vorliegenden Erfindung ist es, neue positiv arbeitende hochaktive strahlungsempfindliche Systeme für die Herstellung von Reliefstrukturen aufzuzeigen, die sich mit wäßrig-alkalischen Lösungen entwickeln lassen und die Herstellung von im kurzwelligen UV lichtempfindlichen Schichten ermöglichen.

Dazu soll ein strahlungsempfindliches Gemisch, das ein in Wasser unlösliches, in wäßrig-alkalischer Lösung lösliches Bindemittel, eine säurelabile organische Verbindung, die durch Einwirkung von Säure verseift und decarboxyliert wird, und eine bei Bestrahlung eine starke Säure bildende Verbindung enthält, bildmäßig bestrahlt, erwärmt und die bildmäßig bestrahlten Schichtbereiche mit Entwicklerlösung ausgewaschen werden.

Überraschenderweise wurde gefunden, daß durch den Einsatz von Malonsäureestern als die Löslichkeit der Bindemittel in wäßrig-alkalischen Lösungen inhibierenden Verbindungen hochaktive strahlungsempfindliche Systeme für die Herstellung von Reliefstrukturen im kurzwelligen UV erhalten werden, die sich besonders durch sehr gute Reproduzierbarkeit und hohe Auflösung auszeichnen.

Gegenstand der vorliegenden Erfindung ist ein strahlungsempfindliches Gemisch, im wesentlichen bestehend aus

(a) einem in Wasser unlöslichen, in wäßrig-alkalischen Lösungen löslichen Bindemittel oder Bindemittelgemisch,

(b) einer bei Bestrahlung eine starke Säure bildenden Verbindung und

(c) einer oder mehreren die Löslichkeit von (a) in wäßrig-alkalischen Lösungen inhibierenden organischen Verbindungen,

das dadurch gekennzeichnet ist, daß die organische Verbindung (c) ein Malonsäureester der allgemeinen Formel (I)

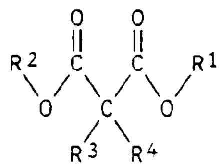

(I)

ist, worin

$R^1$ und $R^2$ untereinander gleich oder verschieden sind und für Alkyl, Cycloalkyl, Aralkyl, Trialkylsilyl oder einen heterocyclischen Rest stehen oder zusammen einen sauerstoffhaltigen, sechsgliedrigen heterocyclischen Ring bilden, sowie

$R^3$ und $R^4$ untereinander gleich oder verschieden sind und für Wasserstoff, Halogen, Alkyl, Cycloalkyl, Alkoxy, Aralkyl, Aryl, am Arylrest halogensubstituiertes Aralkyl oder Aryl stehen,

und als bei Bestrahlung eine starke Säure bildende Verbindung (b) ein Sulfoniumsalz der allgemeinen Formel (II)

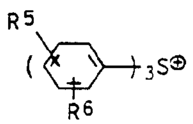

$X^{\ominus}$ (II)

oder Jodoniumsalze der allgemeinen Formel (III)

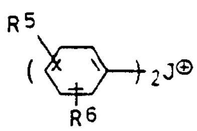

$X^{\ominus}$ (III),

worin $R^5$ und $R^6$ untereinander gleich oder verschieden sind und für H,

OH , 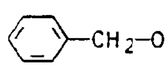 , $(C_1$- bis $C_4$-Alkyl$)_3$Si–O , 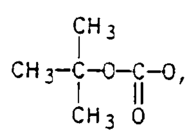

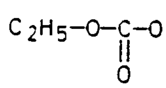 oder 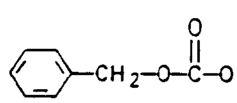

stehen,

und $X^{\ominus}$ = $Cl^{\ominus}$, $Br^{\ominus}$, $ClO_4^{\ominus}$, Hexafluoroarsenat, Hexafluoroantimonat, Hexafluorophosphat und/oder Tetrafluoroborat ist, eingesetzt werden.

Das strahlungsempfindliche Gemisch kann als Bindemittel (a) ein phenolisches Harz, wie beispielsweise Novolake mit mittleren Molekulargewichten $\overline{M}_n$ zwischen 200 und 20 000, Copolymerisate aus p-Hydroxystyrol und p-tert.-Butoxycarbonyloxistyrol, Copolymerisate aus p-Hydroxystyrol und Alkoxystyrol sowie Copolymerisate aus p-Hydroxystyrol und 2-Tetrahydropyranyloxistyrol oder deren Gemische enthalten.

Bevorzugte Malonsäureester sind Brom- oder Chlormalonsäuredialkylester mit 1 bis 4 Kohlenstoffatomen in der Alkylgruppe, Benzyl- und 4-Brombenzylmalonsäuredialkylester mit 1 bis 4 Kohlenstoffatomen in der Alkylgruppe, Malonsäuredibenzylester, Malonsäuredi(trimethylsilyl)ester, Malonsäuredi(tetrahydropyranyl)ester sowie die Cycloisopropylidenester von Brom-methyl-, Brom-ethyl-, Methyl-phenyl- oder Brombenzylmalonsäure.

Gegenstand der vorliegenden Erfindung ist auch ein Verfahren zur Herstellung von Reliefstrukturen oder zur Strukturierung von Wafern durch Auftragen von Photoresistlösungen in einer Schichtdicke von 0,1 bis 5 µm auf ein in üblicher Weise vorbehandeltes Substrat, Trocknen, bildmäßige Belichtung, gegebenenfalls Erhitzen auf Temperaturen von bis zu 150°C, und Entwickeln mit einer wäßrig-alkalischen Lösung, wobei Photoresistlösungen eingesetzt werden, die erfindungsgemäße strahlungsempfindliche Gemische enthalten.

Das erfindungsgemäße Verfahren ist besonders vorteilhaft, da es sehr gute Reproduzierbarkeit gewährleistet. Die damit erhaltenen Reliefstrukturen zeichnen sich durch hohe Auflösung aus.

Zu den Aufbaukomponenten des erfindungsgemäßen strahlungsempfindlichen Gemisches ist im einzelnen folgendes auszuführen.

a) Als in Wasser unlösliche, in wäßrig-alkalischen Lösungen lösliche Bindemittel oder Bindemittelgemische kommen wegen der meist erforderlichen Plasmaätzstabilität im allgemeinen phenolische Harze in Betracht, wie z.B. Novolake mit Molekulargewichten $\overline{M}_n$ zwischen 200 und 20.000, vorzugsweise zwischen 300 und 2000 g/mol, für Belichtung im kurzwelligen UV-Bereich ($\leqq$ 300 nm) insbesondere Novolake auf Basis p-Kresol/Formaldehyd, Poly(p-hydroxystyrole), Poly(p-hydroxy-α-methylstyrole), wobei diese Poly(p-hydroxystyrole) im allgemeinen Molekulargewichte $\overline{M}_n$ zwischen 200 und 100.000, vorzugsweise zwischen 1000 und 40.000 g/mol aufweisen, wobei diese Poly(p-hydroxystyrole) auch in bekannter Weise durch Umsetzung (polymeranaloge Umsetzung) ihrer Hydroxylgruppen mit z.B. Chloressigsäure, Chloressigsäureester, Alkylhalogenid, Benzylhalogenid, 3,4-Dihydropyran, Dihydrofuran, Chlorkohlensäureester und/oder Pyrokohlensäureester modifiziert sein können. Die so erhältlichen und im vorliegenden Falle auch als Copolymerisate verstandenen modifizierten polymeren Bindemittel (a) sind beispielsweise solche aus p-Hydroxystyrol und p-tert.-Butoxycarbonyloxistyrol, p-Hydroxystyrol und Alkoxystyrol, p-Hydroxystyrol und 2-Tetrahydropyranyloxistyrol. Bevorzugte Copolymere von p-Hydroxystyrol, die seitenständige Schutzgruppen tragen, enthalten im wesentlichen Gruppierungen der Formel

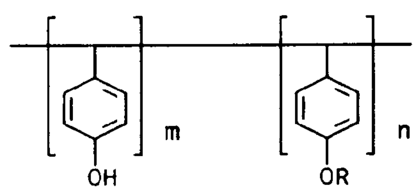

worin n $\leqq$ m und

R = 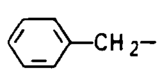 , 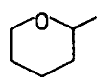 , 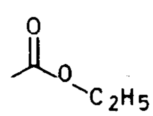 ,

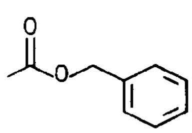 , 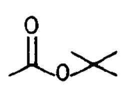 , 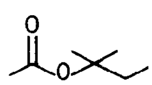

d.h. Copolymere mit p-Benzyl-oxistyrol-, p-(2-Tetrahydropyranyl)-oxistyrol-, p-(iso-Propyl-oxicarbonyl)-oxistyrol-, p-(Cyclohexyl-oxicarbonyl)-oxistyrol-, p-(Benzyloxicarbonyl)-oxistyrol-, p-(t.Butyloxicarbonyl)-oxistyrol- und/oder p-(t.Pentyloxicarbonyl)-oxistyrol-einheiten. Es eignen sich auch Gemische der obengenannten Bindemittel (a). Bindemittel (a) ist im erfindungsgemäßen Gemisch im allgemeinen in Mengen von 45 bis 95, vorzugsweise 80 bis 90 Gew.%, bezogen auf die Gesamtmenge des strahlungsempfindlichen Gemisches (a)+(b)+(c) enthalten.

b) Als bei Bestrahlung eine starke Säure bildende Verbindungen (b) kommen im Prinzip alle Verbindungen in Frage, die diese Eigenschaft aufweisen und so als Säurespender wirksam sind. Für die Bestrahlung mit kurzwelligen UV-Strahlen sind jedoch Iodonium- und insbesondere Sulfoniumsalze bevorzugt. Diese entsprechen der allgemeinen Formel (II) bzw. (III)

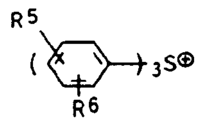 X$^{\ominus}$ (II)

bzw.

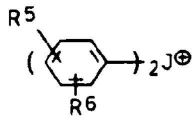 X$^{\ominus}$ (III),

worin

$R^5$ und $R^6$ untereinander gleich oder verschieden sind und für H, (Triphenylsulfoniumsalz bzw. Diphenyljodoniumsalz), OH,

= 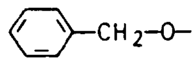 z.B. Tris(4-benzyloxiphenyl)-sulfoniumsalz

= $(C_1$- bis $C_4$-Alkyl$)_3$Si-O- z.B. Tris(trimethylsilyloxy-phenyl)sulfoniumsalz

= 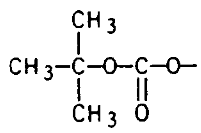 z.B.(Tris(4-tert.-butoxicarbonyloxi-phenyl)sulfoniumsalz

= 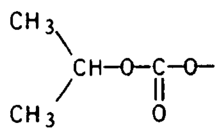 z.B. (Tris(4-isopropyloxicarbonyl-oxiphenyl)sulfoniumsalz)

= 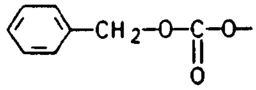 z.B. (Tris(4-benzylcarbonyloxi-phenyl)-sulfoniumsalz)

$X^{\ominus} = Cl^{\ominus}, Br^{\ominus}, ClO_4^{\ominus}, AsF_6^{\ominus}, PF_6^{\ominus}, SbF_6^{\ominus}$ und/oder $BF_4^{\ominus}$.

Auch Gemische der unter (b) genannten Verbindungen können eingesetzt werden. Komponente (b) ist im erfindungsgemäßen strahlungsempfindlichen Gemisch im allgemeinen in Mengen von 0,1 bis 20, vorzugsweise 2 bis 10 Gew.%, bezogen auf die Gesamtmenge des strahlungsempfindlichen Gemisches (a)+(b)+(c) enthalten.

c) Als die Löslichkeit des Bindemittels (a) inhibierende organische Verbindung (c) werden erfindungsgemäß Malonsäureester der allgemeinen Formel (I) eingesetzt,

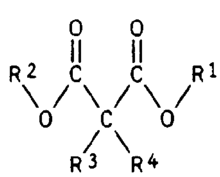 (I)

worin $R^1$ und $R^2$ untereinander gleich oder verschieden sind und für Alkyl, wie z.B. n-Alkyl mit 1 bis 8 Kohlenstoffatomen, z.B. Methyl, Ethyl, n-Propyl, n-Butyl, sec.Alkyl mit 3 bis 7 Kohlenstoffatomen, z.B. Isopropyl, sek.Butyl, tert.-Alkyl mit 4 oder 5 Kohlenstoffatomen, wie tert.Butyl, und tert.Amyl, Cycloakyl mit 5 bis 7 Kohlenstoffatomen, z.B. Cyclohexyl, Aralkyl mit 1 bis 2 Kohlenstoffatomen in der Alkylgruppe, wie z.B.

Benzyl, Trialkylsilyl, z.B. mit 1 bis 4 Kohlenstoffatomen in der Alkylgruppe, wie z.B. Trimethylsilyl, und Triethylsilyl, oder einen heterocyclischen Rest, wie z.B.

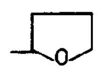 oder 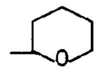

stehen,

oder $R^1$ und $R^2$ zusammen einen sauerstoffhaltigen sechsgliedrigen heterocyclischen Ring, z.B.

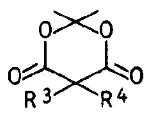

bilden,

$R^3$ und $R^4$ untereinander gleich oder verschieden sind und für Wasserstoff, Halogen, wie z.B. Cl, Br, J, wobei Cl und Br bevorzugt sind, Alkyl, wie z.B. n-Alkyl mit 1 bis 4 Kohlenstoffatomen, z.B. Methyl, Ethyl, n-Propyl oder n-Butyl, Alkoxy, z.B. Methoxy, Ethoxy, Propoxy oder Butoxy, wobei jeweils nur einer der Reste $R^3$ und $R^4$ für eine Alkoxygruppe steht,

Aryl, wie z.B. Phenyl, insbesondere halogensubstituiertes Aryl, wie Chlor- oder Bromphenyl, Aralkyl mit 1 bis 2 Kohlenstoffatomen in der Alkylgruppe, wie Benzyl, halogensubstituiertes Aralkyl, insbesondere Br- oder Cl-substituiertes Aralkyl, beispielsweise 4-Brom-benzyl stehen.

Beispiele derartiger Malonsäureester sind:

Brommalonsäure-diethylester, Chlormalonsäure-di-isobutylester, Brommalonsäure-di-tert.-butylester, Malonsäure-di-trimethylsilylester, Malonsäure-dibenzylester, Malonsäure-di-tetrahydropyranylester, Benzylmalonsäurediethylester, Benzylmalonsäure-di-tert.-butylester, 4-Brombenzylmalonsäure-diethylester, Methylmalonsäurediethylester, Ethyl-malonsäurediethylester, Propyl-malonsäurediethylester, Methyl-malonsäure-di-isobutylester, Ethyl-malonsäure-di-isobutylester, Propyl-malonsäure-di-isobutylester, Methyl-malonsäure-di-tert.-butylester, Ethyl-malonsäure-di-tert.-butylester, Propyl-malonsäure-di-tert.-butylester, Methyl-malonsäure-di(trimethylsilyl)ester, Ethyl-malonsäure-di(trimethylsilyl)ester, Propyl-malonsäure-di(trimethylsilyl)ester, Brommethylmalonsäure-cyclo-isopropylideneste, Bromethylmalonsäure-cyclo-isopropylidenester, Methyl-phenylmalonsäure-cycl.-isopropylidenester, Benzyl-brommalonsäure-cyclo-isopropyliden ester.

Auch Gemische der obengenannten Malonsäureester können eingesetzt werden. Die Malonsäureester (c) sind im erfindungsgemäßen strahlungsempfindlichen Gemisch im allgemeinen in Mengen von 3 bis 35, vorzugsweise 10 bis 25 Gew.%, bezogen auf die Gesamtmenge des Gemisches aus (a), (b) und (c) vorhanden.

Das erfindungsgemäße strahlungsempfindliche Gemisch kann zusätzlich noch weitere übliche Hilfs- und Zusatzstoffe enthalten.

Die erfindungsgemäßen Gemische werden bevorzugt in einem organischen Lösungsmittel gelöst, wobei der Feststoffgehalt im allgemeinen im Bereich zwischen 5 und 40 Gew.% liegt. Als Lösungsmittel kommen bevorzugt aliphatische Ketone, Ether und Ester, sowie Mischungen derselben in Frage. Besonders bevorzugt sind Alkylenglykol-monoalkylether, wie beispielsweise Ethyl-cellosolve, Butylglykol, Methyl-cellosolve und 1-Methoxy-2-propanol, Alkylenglykol-alkylether-ester, wie beispielsweise Methyl-cellosolve-acetat, Ethyl-cellosolve-acetat, Methyl-propylenglykol-acetat und Ethyl-propylenglykol-acetat, Ketone, wie beispielsweise Cyclohexanon, Cyclopentanon und Methyl-ethyl-keton, sowie Acetate wie Butylacetat und Aromaten, wie Toluol und Xylol. Die Auswahl der entsprechenden Lösungsmittel, sowie deren Mischung richtet sich nach der Wahl des jeweiligen phenolischen Polymers, Novolaks und der photoempfindlichen Komponente.

Weiterhin können andere Zusätze wie Haftvermittler, Netzmittel, Farbstoffe und Weichmacher zugesetzt werden.

Gegebenenfalls können auch Sensibilisatoren in geringen Mengen zugesetzt werden, um die Verbindungen im längerwelligen UV- bis hin zum sichtbaren Bereich zu sensibilisieren. Polycyclische Aromaten, wie Pyren und Perylen sind hierfür bevorzugt, jedoch können auch andere Farbstoffe, die als Sensibilisatoren wirken, verwendet werden.

Bei dem erfindungsgemäßen Verfahren zur Herstellung von Reliefmustern wird eine strahlungsempfindliche Aufzeichnungsschicht, die im wesentlichen aus dem erfindungsgemäßen strahlungsempfindlichen Gemisch besteht, bildmäßig in solcher Dosis bestrahlt, daß die Löslichkeit der belichteten Bereiche in wäßrig-alkalischen Lösungsmitteln zunimmt und diese bestrahlten Bereiche selektiv mit dem alkalischen Entwickler

entfernt werden können.

Das erfindungsgemäße strahlungsempfindliche Gemisch eignet sich als Photoresist zur Herstellung von Reliefstrukturen für Halbleiterbauelemente.

Die das erfindungsgemäße strahlungsempfindliche Gemisch enthaltenden Photoresistlösungen werden im allgemeinen in Schichtdicken von 0,1 bis 5 µm, vorzugsweise 0,5 bis 1,5 µm auf geeignete Substrate, beispielsweise oberflächlich oxidierte Silizium-Wafer durch Aufschleudern (spin coating) aufgetragen, getrocknet (z.B. bei Temperaturen zwischen 70 und 130°C) und mit einer geeigneten Lichtquelle durch eine Photomaske bildmäßig belichtet. Als Lichtquellen eignen sich insbesondere kurzwellige UV-Strahlen (deep UV) mit Wellenlängen zwischen 200 und 300 nm. Besonders geeignete Lichtquellen sind Excimer-Laser von KrF (248 nm). Nach dem bildmäßigen Belichten wird - gegebenenfalls nach kurzem Ausheizen (postbake) bei Temperaturen bis zu 150°C - mit üblichen wäßrig-alkalischen Entwicklerlösungen - im allgemeinen bei pH-Werten zwischen 12 und 14 - entwickelt, wobei die belichteten Stellen ausgewaschen werden. Die Auflösung liegt im Submikron-Bereich. Die für die erfindungsgemäßen strahlungsempfindlichen Gemische benötigte Belichtungsenergie liegt im allgemeinen zwischen 30 und 200 $mJ/cm^2$ bei Schichtdicken von 1 µm.

Die in den Beispielen angegebenen Teile und Prozente sind, soweit nicht anders angegeben, Gewichtsteile bzw. Gewichtsprozente.

Beispiel 1

Eine Photoresistlösung wird aus 70 Teilen Poly-(p-hydroxystyrol) (= kommerzielles Produkt der Fa. Polysciences INC, MG 1500-7000), 4 Gew.-Teilen Triphenylsulfoniumhexafluoroarsenat (= kommerzielles Produkt der Fa. ALFA), 16 Teilen Brom-malonsäurediethylester und 270 Teilen Ethylenglykol-monomethyletheracetat hergestellt.

Die Lösung wurde anschließend durch ein Filter mit einem Porendurchmesser von 0,2 µm filtriert.

Die Resistlösung wurde dann auf einen Siliciumwafer mit einer $SiO_2$-Oberfläche, der mit Hexamethyldisilazan als Haftvermittler überzogen ist, mit 4000 Upm/30 Sekunden aufgeschleudert, wobei eine Trockenschichtdicke von etwa 1 µm erhalten wurde. Der Wafer wird während 3 Minuten auf einer Heizplatte bei 80°C getrocknet, anschließend mit einer bildmäßig strukturierten Testmaske in Kontakt gebracht und 2,5 sec mit Excimer-Laser ($\lambda$ = 248 nm, E = 35 $mW/cm^2$) belichtet. Danach wird der Wafer 1 Minute bei 80°C ausgeheizt und mit einem Entwickler vom pH-Wert 12,1-13,4 entwickelt.

Beispiel 2

Eine Photoresistlösung wird aus 80 Teilen Poly-(p-hydroxystyrol), 6 Teilen Triphenylsulfoniumhexafluoroarsenat, 14 Teilen Benzylmalonsäure-diethylester und 270 Teilen Ethylenglykol-monomethyletheracetat hergestellt. Es wird wie in Beispiel 1 verfahren. Die Empfindlichkeit beträgt 110 $mJ/cm^2$.

Beispiel 3

Eine Photoresistlösung wird aus 80 Teilen Poly-(p-hydroxystyrol), 6 Teilen Triphenylsulfoniumhexafluoroarsenat, 14 Teilen Malonsäure-dibenzylester und 270 Teilen Ethylenglykol-monomethyletheracetat hergestellt. Es wird wie in Beispiel 1 verfahren. Die Empfindlichkeit beträgt 130 $mJ/cm^2$.

Beispiel 4

Eine Photoresistlösung wird aus 80 Teilen Poly-(p-hydroxystyrol), 6 Teilen Diphenyljodoniumhexafluorophosphat (kommerzielles Produkt der Fa. ALFA), 14 Teilen Methylmeldrumsäure

( 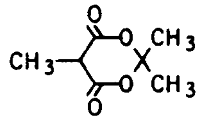 )

und 250 Teilen Ethylenglykol-monomethyletheracetat hergestellt. Es wird wie in Beispiel 1 aber ohne Postbake-Schritt (80°C/1 min nach der Belichtung) verfahren. Die Empfindlichkeit beträgt 40 $mJ)/cm^2$.

## Patentansprüche

1. Strahlungsempfindliches Gemisch, im wesentlichen bestehend aus
   (a) einem in Wasser unlöslichen, in wäßrig-alkalischen Lösungen löslichen Bindemittel oder Bindemittelgemisch,
   (b) einer bei Bestrahlung eine starke Säure bildenden Verbindung und
   (c) einer oder mehreren die Löslichkeit von (a) in wäßrig-alkalischen Lösungen inhibierenden organischen Verbindungen,

   dadurch gekennzeichnet, daß die organische Verbindung (c) ein Malonsäureester der allgemeinen Formel (I)

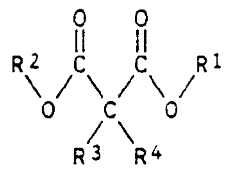

(I)

ist, worin

$R^1$ und $R^2$ untereinander gleich oder verschieden sind und für Alkyl, Cycloalkyl, Aralkyl, Trialkylsilyl oder einen heterocyclischen Rest stehen oder zusammen einen sauerstoffhaltigen, sechsgliedrigen heterocyclischen Ring bilden, sowie

$R^3$ und $R^4$ untereinander gleich oder verschieden sind und für Wasserstoff, Halogen, Alkyl, Cycloalkyl, Alkoxy, Aralkyl, Aryl, am Arylrest halogensubstituiertes Aralkyl oder Aryl stehen,

und als bei Bestrahlung eine starke Säure bildende Verbindung (b) ein Sulfoniumsalz der allgemeinen Formel (II)

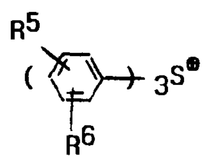

$X^{\ominus}$ (II),

worin $R^5$ und $R^6$ untereinander gleich oder verschieden sind und für H,

OH , 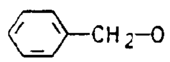 , $(C_1$- bis $C_4$-Alkyl$)_3Si-O$ , 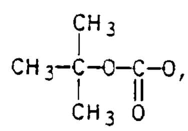

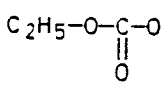 oder 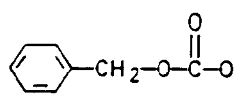

stehen,

und $X^{\ominus}$ = $Cl^{\ominus}$, $Br^{\ominus}$, $ClO_4^{\ominus}$, Hexafluoroarsenat, Hexafluoroantimonat, Hexafluorophosphat und/oder Tetrafluoroborat ist, oder ein Iodoniumsalz der allgemeinen Formel (III)

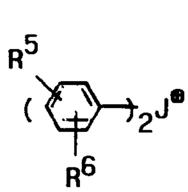

$X^{\ominus}$ (III),

worin $R^5$, $R^6$ und $X^{\ominus}$ die oben angegebene Bedeutung haben, eingesetzt wird.

2. Strahlungsempfindliches Gemisch nach Anspruch 1, dadurch gekennzeichnet, daß als Bindemittel (a) ein phenolisches Harz eingesetzt wird.

3. Strahlungsempfindliches Gemisch nach Anspruch 2, dadurch gekennzeichnet, daß als phenolisches Harz ein Novolak mit einem mittleren Molekulargewicht $\overline{M}_n$ zwischen 200 und 20.000 eingesetzt wird.

4. Strahlungsempfindliches Gemisch nach Anspruch 1, dadurch gekennzeichnet, daß als Bindemittel (a) Poly(p-hydroxystyrol), Poly(p-hydroxy-α-methylstyrol) oder Copolymerisate aus p-Hydroxystyrol und p-tert.-Butoxycarbonyloxistyrol, p-Hydroxystyrol und Alkoxystyrol oder p-Hydroxystyrol und 2-Tetrahydropyranyloxistyrol eingesetzt wird.

5. Strahlungsempfindliches Gemisch nach einem der vorhergehenden Ansprüche, dadurch gekennzeichnet, daß als Malonsäureester der allgemeinen Formel (I) ein Brom- oder Chlormalonsäuredialkylester mit 1 bis 4 Kohlenstoffatomen in der Alkylgruppe eingesetzt wird.

6. Strahlungsempfindliches Gemisch nach einem der Ansprüche 1 bis 4, dadurch gekennzeichnet, daß als Malonsäureester der allgemeinen Formel (I) ein Benzyl- oder 4-Brombenzylmalonsäuredialkylester mit 1 bis 4 Kohlenstoffatomen in der Alkylgruppe eingesetzt wird.

7. Strahlungsempfindliches Gemisch nach einem der Ansprüche 1 bis 4, dadurch gekennzeichnet, daß als Malonsäureester der allgemeinen Formel (I) Malonsäuredialkylester, Malonsäuredi(trimethylsilyl)ester oder Malonsäuredi(tetrahydropyranyl)ester eingesetzt wird.

8. Strahlungsempfindliches Gemisch nach einem der Ansprüche 1 bis 4, dadurch gekennzeichnet, daß als Malonsäureester der allgemeinen Formel (I) ein Cycloisopropylidenester von Brommethyl-, Bromethyl-, Methylphenyl- oder Brombenzylmalonsäure eingesetzt wird.

9. Verfahren zur Herstellung von Reliefstrukturen oder zur Strukturierung von Wafern durch Auftragen von Photoresistlösungen in einer Schichtdicke von 0,1 bis 5 µm auf ein in üblicher Weise vorbehandeltes Substrat, Trocknen, bildmäßige Belichtung, gegebenenfalls Erhitzen auf Temperaturen von bis zu 150°C, und Entwickeln mit einer wäßrig-alkalischen Lösung, dadurch gekennzeichnet, daß Photoresistlösungen eingesetzt werden, die strahlungsempfindliche Gemische gemäß einem der Ansprüche 1 bis 8 enthalten.

## Claims

1. A radiation-sensitive mixture essentially consisting of
   (a) a water-insoluble binder or binder mixture which is soluble in aqueous alkaline solutions,
   (b) a compound which upon irradiation forms a strong acid and
   (c) one or more organic compounds which inhibit the solubility of (a) in aqueous alkaline solutions,
   wherein the organic compound (c) is a malonic acid ester of the general formula (I)

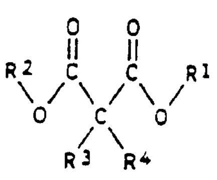

(I)

where

$R^1$ and $R^2$ may be identical or different and each is alkyl, cycloalkyl, aralkyl, trialkylsilyl or a heterocyclic radical, or $R^1$ and $R^2$ together form an oxygen-containing six-membered heterocyclic ring, and

$R^3$ and $R^4$ are identical or different and each is hydrogen, halogen, alkyl, cycloalkyl, alkoxy, aralkyl, aryl, aralkyl which is halogen-substituted in the aryl moiety or halogen-substituted aryl,

and the compound (b) which on irradiation forms a strong acid is a sulfonium salt of the general formula (II)

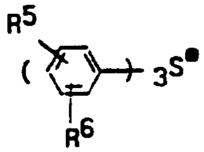 $X^{\ominus}$ (II)

where $R^5$ and $R^6$ may be identical or different and each is H, OH or one of the radicals

OH, 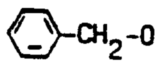 , $(C_1\text{-}C_4\text{-alkyl})_3Si\text{-}O$, 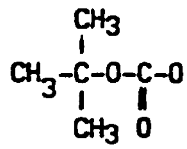 ,

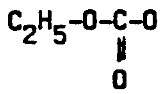 and 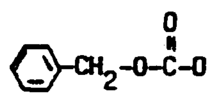

and $X^{\ominus}$ = $Cl^{\ominus}$, $Br^{\ominus}$, $ClO_4^{\ominus}$, hexafluoroarsenate, hexafluoroantimonate, hexafluorophosphate and/or tetrafluoroborate, or an iodonium salt of the general formula (III)

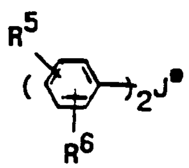 $X^{\ominus}$ (III)

where $R^5$, $R^6$ and $X^{\ominus}$ are as defined above.

2. A radiation-sensitive mixture as claimed in claim 1, wherein the binder (a) is a phenolic resin.

3. A radiation-sensitive mixture as claimed in claim 2, wherein the phenolic resin is a novolak having a mean molecular weight $\overline{M}_n$ of from 200 to 20,000.

4. A radiation-sensitive mixture as claimed in claim 1, wherein the binder (a) is poly(p-hydroxystyrene), poly(p-hydroxy-α-methylstyrene) or a copolymer of p-hydroxystyrene and p-tert.-butoxycarbonyloxystyrene, p-hydroxystyrene and an alkoxystyrene or p-hydroxystyrene and 2-tetrahydropyranyloxystyrene.

5. A radiation-sensitive mixture as claimed in any of the preceding claims, wherein the malonic acid ester of the general formula (I) is a dialkyl bromomalonate or chloromalonate, where alkyl is of 1 to 4 carbon atoms.

6. A radiation-sensitive mixture as claimed in any of claims 1 to 4, wherein the malonic acid ester of the general formula (I) is a dialkyl benzylmalonate or 4-bromobenzylmalonate, where alkyl is of 1 to 4 carbon atoms.

7. A radiation-sensitive mixture as claimed in any of claims 1 to 4, wherein the malonic acid ester of the general formula (I) is dialkyl malonate, di(trimethylsilyl) malonate or di(tetrahydropyranyl) malonate.

8. A radiation-sensitive mixture as claimed in any of claims 1 to 4, wherein the malonic acid ester of the general formula (I) is a cycloisopropylidene ester of bromomethylmalonic acid, bromoethylmalonic acid, methylphenylmalonic acid or bromobenzylmalonic acid.

9. A process for the preparation of relief structures or for the structuring of wafers by applying a photoresist solution in a thickness of from 0.1 to 5 μm onto a conventionally pretreated substrate, drying the coating, exposing it imagewise with or without subsequent heating at up to 150°C, and developing with an aqueous

alkaline solution, wherein the photoresist solution employed contains a radiation-sensitive mixture as claimed in any of claims 1 to 8.

## Revendications

1. Mélange sensible au rayonnement, constitué essentiellement
   (a) d'un liant ou mélange de liants, insoluble dans l'eau, soluble dans des solutions alcalines aqueuses,
   (b) d'un composé formant un acide fort sous irradiation et
   (c) d'un ou plusieurs composés organiques inhibant la solubilité de (a) dans des solutions alcalines aqueuses,

   caractérisé par le fait que le composé organique (c) est un ester d'acide malonique de formule générale (I)

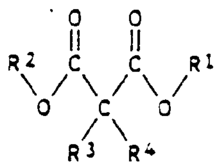

(I)

dans laquelle
$R^1$ et $R^2$ sont identiques ou différents et sont mis pour alkyle, cycloalkyle, aralkyle, trialkylsilyle ou un reste hétérocyclique, ou forment ensemble un hétérocycle oxygéné à six chaînons, et
$R^3$ et $R^4$ sont identiques ou différents et sont mis pour hydrogène, halogène, alkyle, cycloalkyle, alcoxy, aralkyle, aryle, aralkyle ou aryle substitués sur le reste aryle par halogène,
et (b), en tant que composé formant un acide fort sous irradiation, est un sel de sulfonium de formule générale (II)

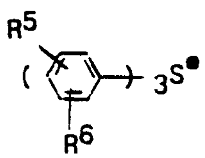

(II),

dans laquelle $R^5$ et $R^6$ sont identiques ou différents et sont mis pour H,

OH,

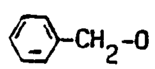 , $(C_1$- bis $C_4$-Alkyl$)_3$Si-O , 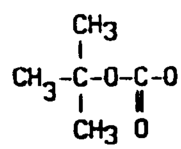 ,

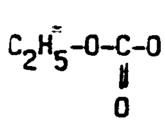 ou 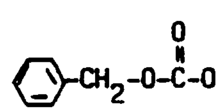

et $X^{\circ}$ = $Cl^{\circ}$, $Br^{\circ}$, $ClO_4^{\circ}$, hexafluorarsénate, hexafluorantimonate, hexafluorophosphate et/ou tétrafluoroborate, ou l'on utilise un sel d'iodonium de formule générale III

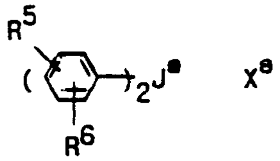 (III),

où $R^5$, $R^6$ et $X^o$ ont les significations données plus haut.

**2.** Mélange sensible au rayonnement selon la revendication 1, caractérisé par le fait que l'on utilise une résine phénolique comme liant (a).

**3.** Mélange sensible au rayonnement selon la revendication 2, caractérisé par le fait que l'on utilise comme résine phénolique une novolaque d'un poids moléculaire moyen $\overline{M}_n$ compris entre 200 et 20 000.

**4.** Mélange sensible au rayonnement selon la revendication 1, caractérisé par le fait que l'on utilise comme liant (a) du poly(p-hydroxystyrène), du poly(p-hydroxy-α-méthylstyrène) ou des copolymérisats de p-hydroxystyrène et de p-ter-butoxycarbonyloxystyrène, de p-hydroxystyrène et d'alcoxystyrène ou de p-hydroxystyrène et de 2-tétrahydropyranyloxystyrène.

**5.** Mélange sensible au rayonnement selon l'une des revendications précédentes, caractérisé par le fait que l'on utilise comme ester d'acide malonique de formule générale (I), un bromo- ou chloro-malonate de dialkyle ayant 1 à 4 atomes de carbone dans le groupe alkyle.

**6.** Mélange sensible au rayonnement selon l'une des revendications 1 à 4, caractérisé par le fait que l'on utilise comme ester d'acide malonique de formule générale (I), un benzyl- ou 4-bromobenzylmalonate de dialkyle ayant 1 à 4 atomes de carbone dans le groupe alkyle.

**7.** Mélange sensible au rayonnement selon l'une des revendications 1 à 4, caractérisé par le fait que l'on utilise comme ester d'acide malonique de formule générale (I), des malonates de dialkyle, des malonates de di(triméthylsilyle) ou des malonates de di(tétrahydropyranyle).

**8.** Mélange sensible au rayonnement selon l'une des revendications 1 à 4, caractérisé par le fait que l'on utilise comme ester d'acide malonique de formule générale (I), un ester de cycloisopropylidène et d'acide bromométhyl-, brométhyl-, méthylphényl- ou bromobenzylmalonique.

**9.** Procédé pour préparer des structures à reliefs ou imprimer des structures à des "wafers" en appliquant des solutions pour réserves photographiques, en une épaisseur de couche de 0,1 à 5 μm, sur un subjectile soumis à un prétraitement usuel, en séchant, exposant à la lumière selon l'image, chauffant éventuellement à des températures allant jusqu'à 150°C et en développant avec une solution alcaline aqueuse, caractérisé par le fait que l'on utilise des solutions pour réserves photographiques contenant des mélanges sensibles au rayonnement conformes à l'une des revendications 1, 2, 3, 4, 5, 6, 7 ou 8.